# EUROPÄISCHE PATENTSCHRIFT

(11) **EP 1 184 867 B1**
(45) Veröffentlichungstag und Bekanntmachung des Hinweises auf die Patenterteilung: **20.06.2007**
(21) Anmeldenummer: 01118267.2
(22) Anmeldetag: 30.07.2001
(51) Int. Cl.: G11C 7/10

(54) **Integrierte Halbleiterschaltung mit in einem Halbleiterchip eingebetteter Halbleiterspeicheranordnung**
Integrated semiconductor circuit with embedded semiconductor memory
Circuit intégré à semi-conducteurs avec un circuit de mémoire à semi-conducteurs intégré sur la même puce

(30) Priorität: 23.08.2000 DE 10041377
(43) Veröffentlichungstag der Anmeldung: 06.03.2002
(73) Patentinhaber: Infineon Technologies AG, 81669 München (DE)
(72) Erfinder: Baenisch, Andreas, 81737 München (DE); Troost, Marco, 81477 München (DE)
(74) Vertreter: Müller - Hoffmann & Partner

(56) Entgegenhaltungen:
- EP-A- 0 488 678
- EP-A- 0 910 091
- WO-A-01/22423
- US-A- 4 961 169

## Beschreibung

Die Erfindung betrifft eine integrierte Halbleiterschaltung mit einer in einem Halbleiterchip eingebetteten Halbleiterspeicheranordnung (Array) und einer Interfaceschaltung, die über einen Secondary-Sense-Verstärkerblock mit Secondary-Sense-Verstärkern und einen Spaltendecoderblock mit Spaltendecodern zur Verbindung und Übertragung von Daten- und Steuersignalen zwischen der Halbleiterspeicheranordnung und einer sie umgebenden Schaltungsperipherie eingerichtet und auf demselben Halbleiterchip integriert ist, wobei Senseleitungen von Primary-Sense-Verstärkern über die Interfaceschaltung zu den Secondary-Sense-Verstärkern führen, die die von der Halbleiterspeicheranordnung ausgelesenen Daten verstärken und den Spaltendecodern zuführen.

Integrierte Halbleiterschaltungen, die nach Anwenderwünschen gestaltet sind (sogenannte ASICs) werden häufig zusammen mit eingebetteten Halbleiterspeicheranordnungen realisiert, um die herum dann die nach Anwenderspezifikationen realisierte Halbleiterschaltung auf demselben Halbleiterchip integriert ist. Dabei kommt es häufig vor, daß verschiedene Anwender hinsicht lich Größe und Organisation unterschiedliche Halbleiterzellenfelder wünschen.

Aus diesem Grund wurde bisher eine Interfaceschaltung zwischen dem Halbleiterspeicherzellenfeld und der Schaltungsperipherie je nach Größe und Organisation der Zellenfelder in verschiedenen Ausführungen in den entsprechenden Produkten realisiert. Dabei traten häufig Probleme an den Randbereichen des Zellenfeldes auf. Derartige Probleme, wie geometrische Fehler, die Designregeln verletzten, traten im Stand der Technik häufig durch eine zu enge Auslegung, beispielsweise bedingt durch zu breite Leiterbahnen für die Leistungszufuhr auf.

EP-A-0 910 091 enthält in ein und derselben integrierten Halbleiterschaltung mehrere sogenannte "single-port memory arrays", die in verschiedenen Konfigurationen programmiert und betrieben werden können, zum Beispiel in einer 2Kx1, 1Kx2, 512x4 oder 256x8 Konfiguration. Zur Anpassung an die jeweilige Konfiguratin werden einem Spaltendecoder und Datenselektionslogikabschnitt sowie einem Lesedatenlogikabschnitt vier Bitstellen umfassende Modeselektsignale zugeführt. Eingabemultiplexer an denen n Bits von Daten-, Adress- und Steuerleitungen anliegen sind zur Anpassung an die jeweils gewählte Datenkonfiguration des 64x32 RAM Zellenfeldes programmierbar ausgeführt. Bei der in dieser Druckschrift beschriebenen integrierten Halbleiterschaltung ist bei der Organisation der Bitbreite des Speicherarrays beim Einschreiben und beim Auslesen von Daten immer das gesamte Speicherfeld betroffen. Die Einstellung bzw. Organisation der Bitbreite des Speicherfeldes der aus dieser Druckschrift bekannten integrierten Halbleiterschaltung ist durch eine aufwändige Adressier- und Auswahllogik, die durch ein jeweiliges Schreibmodusauswahl- und Lesemodusauswahlsignal eingestellt wird, bei jedem Schreib- und Lesezugriff änderbar. Ferner ist die Bitbreite des Speicherfeldes bei der aus der Druckschrift bekannten integrierten Halbleiterschaltung nicht bitweise einstellbar.

Es ist Aufgabe der Erfindung eine integrierte Halbleiterschaltung mit in einem Halbleiterchip eingebetteter Halbleiterspeicheranordnung anzugeben, die die oben geschilderten Probleme im Randbereich des Zellenfeldes vermeiden kann und die bei Zellenfeldern des Speichers in unterschiedlicher Größe und Organisation im wesentlichen ohne Flächenverlust bei der Integration eine kostengünstige und sichere Lösung bieten.

Gemäß einem wesentlichen Aspekt dieser Erfindung wird die obige Aufgabe dadurch gelöst, dass die Interfaceschaltung als Standardinterface gleichartig für alle Typen integrierter Halbleiterschaltungen, die mit einer eingebetteten Halbleiterspeicheranordnung (Array) versehen sind, für die größte realisierbare Bitbreite (n) der Halbleiterspeicheranordnung (Array) gestaltet ist und eine Schalteranordnung aufweist, um die bei kleineren Bitbreiten unbenutzten Bits des Standardinterfaces abzuschalten, und dass die in der Halbleiterspeicheranordnung vorgesehene Anzahl der Spaltendecoder im Spaltendecoderblock und die vorgesehene Anzahl der Secondary-Sense-Verstärker im Secondary-Sense-Verstärkerblock der jeweiligen Bitbreite entsprechen.

Es existiert kein Flächenverlust, da das Zellenfeld stets gleich groß ist und immer nur die Anzahl der Spaltendecoder und Secondary-Sense-Verstärker angepaßt werden muß.

Dabei beträgt die derzeit realisierbare maximale Bitbreite eines Zellenfeldes einer eingebetteten Halbleiterspeicheranordnung zum Beispiel 64 Bit.

Die nachstehende Beschreibung beschreibt ein Ausführungsbeispiel der erfindungsgemäßen integrierten Halbleiterschaltung bezogen auf die Zeichnung. Die Zeichnungsfiguren zeigen im einzelnen:
- Fig. 1: blockartig eine auf einem Halbleiterchip integrierte Halbleiterschaltung mit eingebetteter Halbleiterspeicheranordnung,
- Fig. 2: schematisch eine eingebettete Halbleiterspeicheranordnung gemäß Fig. 1 mit vier 2M Zellenfeldern und
- Fig. 3: schematisch ein Ausführungsbeispiel einer in eine Halbleiterschaltung eingebetteten Halbleiterspeicheranordnung mit einem erfindungsgemäßen Standardinterface.

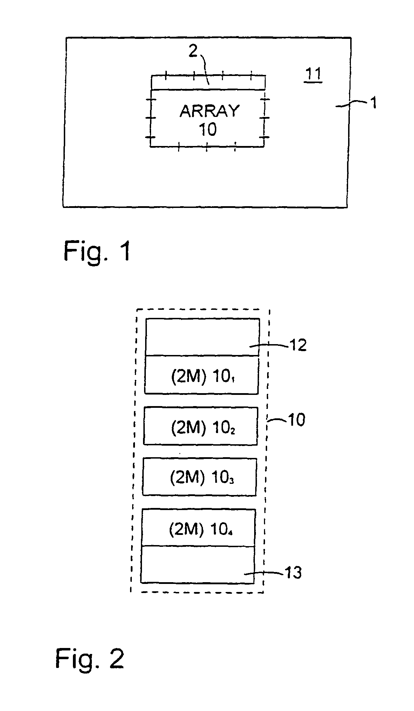

Gemäß Fig. 1 weist eine in einem Halbleiterchip 1 integrierte Halbleiterschaltung eine eingebettete Halbleiterspeicheranordnung oder ein Speicherarray 10 mit einer Interfaceschaltung 2 zur Verbindung und Übertragung von (nicht gezeigten) Daten- und Steuersignalen zwischen der Halbleiterspeicheranordnung 10 und einer sie umgebenden auf demselben Chip 1 integrierten Schaltungsperipherie 11 auf.

Wie erwähnt kann das Speicherarray 10 je nach Anwenderwunsch hinsichtlich Größe und Organisation unterschiedliche Zellenfelder aufweisen.

Das Speicherarray 10 in Fig. 2 enthält beispielhaft vier 2 MBit Zellenfelder 10₁, 10₂, 10₃ und 10₄ mit einem Generatorblock 12 und einem Secondary-Sense-Verstärker- und Dekodierlogikblock 13.

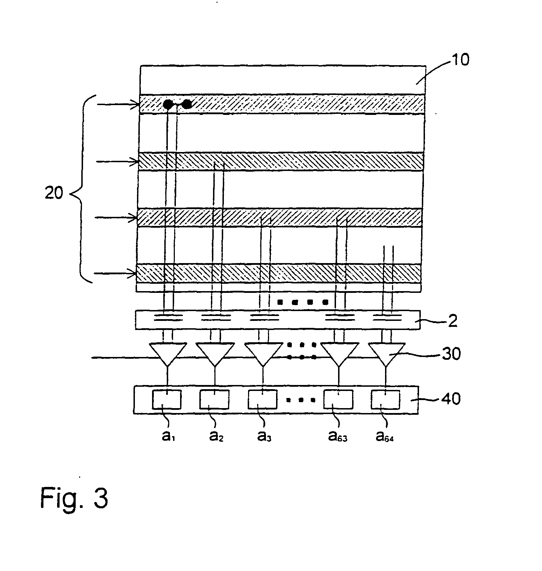

In Fig. 3 sind von einem Zellenfeld einer eingebetteten Halbleiterspeicheranordnung 10 gemäß Fig. 2 lediglich die Primary-Sense-Verstärker 20 durch schraffierte Zeilen angedeutet. Von den Primary-Sense-Verstärkern 20 führen Senseleitungen über eine erfindungsgemäß als Standardinterface ausgeführte Interfaceschaltung 2 zu Secondary-Sense-Verstärkern 30, die die von der Halbleiterspeicheranordnung ausgelesenen Daten verstärken und einem Spaltendecoder 40 zuführen, der in dem in Fig. 3 dargestellten Beispiel 64 Lesedatenausgangspads A1 - A64 enthält.

Erfindungsgemäß ist das Standardinterface 2 für die größte Bitbreite, im Beispiel 64 Bit, der eingebetteten Halbleiterspeicheranordnung 10 ausgelegt. Das Standardinterface weist eine (nicht gezeigte) Schalteranordnung auf, mit der unbenutzte Bits, wenn eine geringere Bitbreite der Halbleiterspeicheranordnung 10 realisiert werden soll, abgeschaltet werden.

Somit ist das Zellenfeld der Halbleiterspeicheranordnung 10 immer gleich groß und durch die Realisierung des Standardinterfaces mit der größten Bitbreite brauchen nur die Anzahl der Spaltendecoder im Decoderblock 40 und die Anzahl der Secondary-Sense-Verstärker im Verstärkerblock 30 angepaßt werden.

Aufwendige und eventuell Geometriefehler hervorrufende Anpassungsarbeiten an den Randbereichen des Zellenfeldes sind damit vermieden.

Somit können sämtliche Typen von mit einer eingebetteten Halbleiterspeicheranordnung versehenen integrierten Halbleiterschaltungen mit einem einheitlichen Standardinterface zwischen Zellenfeld und Spaltendecoder bzw. Secondary-Sense-Verstärker integriert werden.

## Patentansprüche

1. Integrierte Halbleiterschaltung mit einer in einem Halbleiterchip (1) eingebetteten Halbleiterspeicheranordnung (Array 10) und einer Interfaceschaltung (2), die über einen Secondary-Sense-Verstärkerblock mit Secondary-Sense-Verstärkern (30) und einen Spaltendecoderblock mit Spaltendecodern (40) zur Verbindung und Übertragung von Daten- und Steuersignalen zwischen der Halbleiterspeicheranordnung (10) und einer sie umgebenden Schaltungsperipherie (11) eingerichtet und auf demselben Halbleiterchip (1) integriert ist, wobei Senseleitungen von Primary-Sense-Verstärkern (20) über die Interfaceschaltung (2) zu den Secondary-Sense-Verstärkern (30) führen, die die von der Halbleiterspeicheranordnung (10) ausgelesenen Daten verstärken und den Spaltendecodern (40) zuführen,
**dadurch gekennzeichnet,**
**dass** die Interfaceschaltung (2) als Standardinterface gleichartig für alle Typen integrierter Halbleiterschaltungen, die mit einer eingebetteten Halbleiterspeicheranordnung (Array 10) versehen sind, für die größte realisierbare Bitbreite (n) der Halbleiterspeicheranordnung (Array 10) gestaltet ist und
eine Schalteranordnung aufweist, um die bei kleineren Bitbreiten unbenutzten Bits des Standardinterfaces (2) abzuschalten, und
**dass** die in der Halbleiterspeicheranordnung vorgesehene Anzahl der Spaltendecoder im Spaltendecoderblock (40) und die vorgesehene Anzahl der Secondary-Sense-Verstärker (30) im Secondary-Sense-Verstärkerblock der jeweiligen Bitbreite entsprechen.

2. Integrierte Halbleiterschaltung nach Anspruch 1,
**dadurch gekennzeichnet,**
**dass** die Standardinterfaceschaltung (2) zwischen dem Zellenfeld der Halbleiterspeicheranordnung (Array 10) und deren Spaltendecoderblock (40) bzw. dem Secondary-Sense-Verstärkerblock (30) vorgesehen ist.

3. Integrierte Halbleiterschaltung nach Anspruch 1 oder 2,
**dadurch gekennzeichnet,**
**dass** die maximale Bitbreite (n) 64 ist.

## Claims

1. Integrated semiconductor circuit with a semiconductor memory arrangement (array 10) embedded in a semiconductor chip (1) and an interface circuit (2), which is set up via a secondary sense amplifier block with secondary sense amplifiers (30) and a column decoder block with column decoders (40) for the connection and transfer of data and control signals between the semiconductor memory arrangement (10) and a circuit periphery (11) surrounding it and is integrated on the same semiconductor chip (1), sense lines leading from primary sense amplifiers (20) via the interface circuit (2) to the secondary sense amplifiers (30), which amplify the data read out from the semiconductor memory arrangement (10) and feed them to the column decoders (40),
**characterized in that**
the interface circuit (2) is configured as a standard interface identically for all types of integrated semiconductor circuits which are provided with an embedded semiconductor memory arrangement (array 10) for the largest bit width (n) that can be realized in the semiconductor memory arrangement (array 10) and has a switch arrangement in order to switch off the bits of the standard interface (2) which are unused in the case of smaller bit widths, and
the number of column decoders in the column decoder block (40) that are provided in the semiconductor memory arrangement and the provided number of secondary sense amplifiers (30) in the secondary sense amplifier block correspond to the respective bit width.

2. Integrated semiconductor circuit according to Claim 1,
**characterized in that**
the standard interface circuit (2) is provided between the cell array of the semiconductor memory arrangement (array 10) and the column decoder block (40) thereof or the secondary sense amplifier block (30).

3. Integrated semiconductor circuit according to Claim 1 or 2,
**characterized in that**
the maximum bit width (n) is 64.

## Revendications

1. circuit intégré à semi-conducteurs comprenant un dispositif de mémoire à semi-conducteurs (array 10) incorporé dans une puce à semi-conducteurs et un circuit (2) d'interface, qui est interposé, par l'intermédiaire d'un bloc amplificateur sense secondaire à amplificateurs (30) sense secondaires et d'un bloc décodeur de colonne à décodeurs (40) de colonne, pour la liaison et la transmission de signaux de données et de commande entre le dispositif (10) de mémoire à semi-conducteurs et une périphérie (11) de circuit qui l'entoure et qui est intégré sur la même puce à semi-conducteurs, des lignes sense d'amplificateurs (20) sense primaires menant par le circuit (2) d'interface aux amplificateurs (30) sense secondaires qui amplifient les données lues par le dispositif à semi-conducteurs et les envoient aux décodeurs (40) de colonne
**caractérisé**
**en ce que** le circuit (2) d'interface est conformé sous la forme d'une interface standard de la même façon pour tous les types de circuit intégré à semi-conducteurs, qui sont munis d'un dispositif de mémoire à semi-conducteurs (array 10) incorporé, pour la largeur (n) de bits la plus grande qui puisse être réalisé du dispositif de mémoire à semi-conducteur (array 10) etaà un dispositif d'interrupteur pour arrêter les bits de l'interface (2) standard, qui ne sont pas utilisés si la largeur de bits est plus petite et,
**en ce que** le nombre, prévu dans le dispositif de mémoire à semi-conducteurs, des décodeurs de colonne du bloc (40) décodeur de colonne et le nombre, prévu des amplificateurs (30) sense secondaires, du bloc d'amplificateurs sense secondaires correspondent à la largeur de bit respective.

2. Circuit intégré à semi-conducteurs suivant la revendication 1,
**caractérisé**
**en ce que** le circuit d'interface standard est prévu entre le champ de cellules du dispositif de mémoire à semi-conducteurs (array 10) et son bloc (40) décodeur de colonne ou le bloc (30) d'amplificateurs sense secondaires.

3. Circuit intégré à semi-conducteurs suivant la revendication 1 ou 2,
**caractérisé**
**en ce que** la largeur (n) maximum de bits est de 64.
